# EUROPEAN PATENT SPECIFICATION

(11) **EP 3 022 779 B1**
(45) Date of publication and mention of the grant of the patent: **18.03.2020**
(21) Application number: 14766210.0
(22) Date of filing: 17.07.2014
(51) Int. Cl.: H01L 33/62, H01L 33/00

(54) **PC LED WITH OPTICAL ELEMENT AND WITHOUT SUBSTRATE CARRIER**
PC-LED MIT OPTISCHEM ELEMENT UND OHNE SUBSTRATTRÄGER
DEL DE PC À ÉLÉMENT OPTIQUE ET SANS SUBSTRAT DE SUPPORT

(30) Priority: 19.07.2013 US 201361856103 P
(43) Date of publication of application: 25.05.2016
(73) Proprietor: Lumileds Holding B.V., 1118 CL Schiphol (NL)
(72) Inventor: BASIN, Grigoriy, NL-5656 AE Eindhoven (NL); HAQUE, Ashim Shatil, NL-5656 AE Eindhoven (NL); KAGEYAMA, Hideo, NL-5656 AE Eindhoven (NL); MORAN, Brendan Jude, NL-5656 AE Eindhoven (NL); BHARDWAJ, Jyoti Kiron, NL-5656 AE Eindhoven (NL)
(74) Representative: ter Heegde, Paul Gerard Michel
(86) International application number: PCT/IB2014/063169
(87) International publication number: WO 2015/008243

(56) References cited:
- US-A1- 2009 121 245
- US-A1- 2009 283 783
- US-A1- 2010 133 564
- US-A1- 2012 098 110
- US-B1- 6 440 765

## Description

### FIELD OF THE INVENTION

This invention relates to the field of light emitting devices, and in particular to a light emitting device (LED) that is suitable for attachment to a printed circuit (PC) or other fixture, and includes an optical element, but does not include a substrate carrier.

### BACKGROUND OF THE INVENTION

The ever expanding use of semiconductor light emitting devices has produced a highly competitive market for these devices. In this market, performance and price are often significant for providing product distinction among vendors.

US 2009/0121245 A1 discloses an optoelectronic semiconductor chip which emits electromagnetic radiation from its front side during operation. The chip is provided with a self-supporting and electrically conductive mechanical supporting layer formed on a semiconductor layer sequence and is transmissive for radiation. The chip has electrical contacts at opposite sides of the chip.

One technique for reducing the cost of the device is to reduce material costs by reducing the number of components forming the device and/or using less costly components. Additionally or alternatively, the cost of the device may be reduced by reducing the manufacturing costs by reducing the number of manufacturing processes and/or using less costly manufacturing processes.

One technique used to reduce manufacturing costs is to process multiple devices during each manufacturing step. However, the processing of multiple devices often requires the use of components that are provided primarily to accommodate the manufacturing process.

In the manufacture of light emitting devices, hundreds of light emitting elements are produced/grown on a growth substrate, with minimal 'wasted' space between the light emitting elements. These light emitting elements are generally substantially smaller than the eventual size of the light emitting device, because the light emitting device generally requires an optical element that serves to provide a desired light output pattern and also serves to protect the light emitting element; the light emitting device may also include a wavelength conversion element to produce a composite multi-wavelength light output, such as white light. Accordingly, space must be provided between the light emitting elements that are to receive these additional components.

To situate the light emitting elements at an appropriate spacing to allow the optical and other elements to be added to multiple light emitting elements during a single process, the growth substrate is sliced/diced to provide individual ('singulated') light emitting elements, and these light emitting elements are attached to a substrate carrier that is formed to create an array of appropriately spaced light emitting elements. The substrate carrier is generally also configured to facilitate subsequent mounting and packaging requirements, including providing external electrical contact to the light emitting elements.

After the light emitting elements are mounted upon the substrate carrier, typically by soldering the contact pads of the light emitting element to conductors that provide for the external electrical contact on the substrate carrier, the optical elements and optional wavelength conversion elements are applied to the multiple light emitting elements on the substrate carrier. Thereafter, the substrate carrier is sliced/diced to provide the individual ('singulated') light emitting devices.

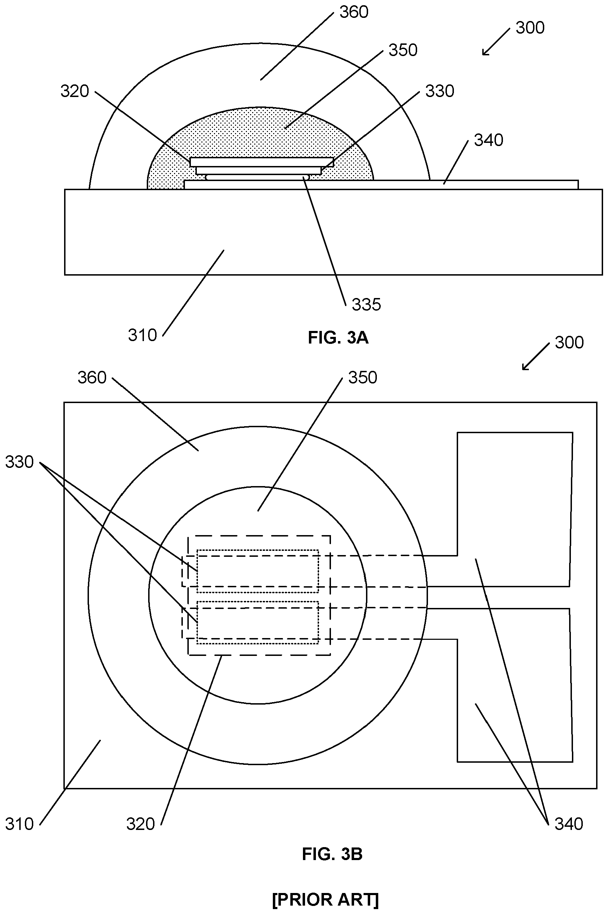

FIGs. 3A-3B illustrate a profile view and a top view of an example prior art singulated light emitting device 300. The light emitting device 300 includes a light emitting element 320, or chip, that is 'flip-chip' mounted upon a singulated portion of a substrate carrier 310, conventionally termed a 'submount' 310. When the light emitting element 320 is formed on the growth substrate (not-shown), the semiconductor layers forming the light emitting element 320 are grown first, and the conductive layers forming the contact to the semiconductor layers are grown atop the semiconductor layers, with contact pads 330 at the uppermost layer. A flip-chip mounting provides the contact pads 330 on the lower surface of the light emitting element 320, and the majority of light is emitted from the upper surface of the light emitting element 320. In this example, the growth substrate upon which the light emitting element 320 had been grown has been removed, to increase the light output efficiency.

The submount 310 includes conductors 340 that provide for external contact to contact pads 330 on the lower surface of the light emitting element 320, and the contact pads 330 are attached to these conductors 340, typically using a solder layer 335. The submount 310 may also include reflective material (not shown) to redirect light away from the submount 310.

During the processing of the un-singulated substrate carrier, a wavelength conversion element 350 has been attached to each of light emitting elements 320, and an optical element 360 has been applied above the wavelength conversional material 350. Optionally, the wavelength conversion material, such as phosphor particles, may be included within the material used to form the optical element 360, eliminating the need for separate applications of these elements 350, 360.

Upon singulation, the finished light emitting device 300 includes the submount 310, the light emitting element 320, the optical and wavelength conversion elements 350, 360, and external connections 340 to the light emitting element. Of particular note, the submount 310 defines the overall dimensions of the finished light emitting device 300. If a larger optical element is desired for a particular application, a different submount must be designed; if a smaller optical element is sufficient for a particular application, either a different submount must be designed, or a loss of useful area may be incurred. Additionally, some applications may require multiple light emitting devices in a particular arrangement, and the dimensions of the submount 310 may preclude the desired arrangement, again requiring the design of a different submount.

Other techniques that do not use a submount, per se, are also commonly used to produce a packaged light emitting device. Leadframes and leadframe carriers are commonly used to facilitate the manufacture of multiple light emitting devices during each process.

A leadframe is generally a conductive structure that provides contacts (leads) for externally connecting to a light emitting element. The two contact pads on the light emitting element are soldered to the ends of two leads that extend away from the light emitting element. The leads may be shaped and bent to situate the opposite ends of the leads in the appropriate location and orientation for subsequent mounting on a printed circuit board or other fixture.

The leadframe carrier comprises multiple leadframes, and allows for subsequent processing of multiple light emitting elements on the leadframe carrier. For example, optical elements may be molded over the leadframe carrier before the individual light emitting elements on leadframes are singulated. Typically, the molded element extends beneath the surface of the leads upon which the light emitting element is soldered, effectively forming a substrate carrier comprising molded material and conductors (leads) beneath the light emitting element.

As in the above example of a submount, the formed substrate carrier about each leadframe with light emitting element effectively defines the dimensions of the finished product. If more or less space is required between leadframes on a leadframe carrier to accommodate larger or smaller optical elements, a new leadframe carrier is likely to be required.

In each of these examples, one of the primary functions of the substrate carrier is to provide a structure that allows for the placement and processing of multiple singulated light emitting elements, and in particular, to facilitate the formation of an optical element above each singulated light emitting element. Another primary function of the substrate carrier is to provide a reflective surface that redirects light into the optical element for emission from the light emitting device.

### SUMMARY OF THE INVENTION

It would be advantageous to provide a method of producing multiple light emitting devices that include a light emitting element and an optical element but do not include a substrate carrier. It would also be advantageous to provide a method of producing light emitting devices of different dimensions without requiring different components to accommodate the different dimensions.

To better address one or more of these concerns, in an embodiment of this invention, intermediate removable placement and processing structures are provided to enable the formation of optical elements upon the light emitting element, including the formation of a reflective layer beneath the optical elements. These removable placement and processing structures are substantially independent of the particular dimensions of the produced light emitting device, allowing their re-use in a variety of applications. The resultant light emitting device includes the light emitting element, the optical element with reflector, and, optionally, a wavelength conversion material, but does not include remnants of the placement and processing structures, such as a carrier substrate.

### BRIEF DESCRIPTION OF THE DRAWINGS

The invention is explained in further detail, and by way of example, with reference to the accompanying drawings wherein:
FIGs. 1A-1F illustrate an example process for forming a light emitting element with a wavelength conversion element.
FIGs. 2A-2F illustrate an example process for forming a light emitting device with a light emitting element and an optical element, without a carrier substrate.
FIGs. 3A-3B illustrate an example prior art light emitting device with a light emitting element, an optical element, and a carrier substrate element.

Throughout the drawings, the same reference numerals indicate similar or corresponding features or functions. The drawings are included for illustrative purposes and are not intended to limit the scope of the invention.

### DETAILED DESCRIPTION

In the following description, for purposes of explanation rather than limitation, specific details are set forth such as the particular architecture, interfaces, techniques, etc., in order to provide a thorough understanding of the concepts of the invention. However, it will be apparent to those skilled in the art that the present invention may be practiced in other embodiments, which depart from these specific details. In like manner, the text of this description is directed to the example embodiments as illustrated in the Figures, and is not intended to limit the claimed invention beyond the limits expressly included in the claims. For purposes of simplicity and clarity, detailed descriptions of well-known devices, circuits, and methods are omitted so as not to obscure the description of the present invention with unnecessary detail.

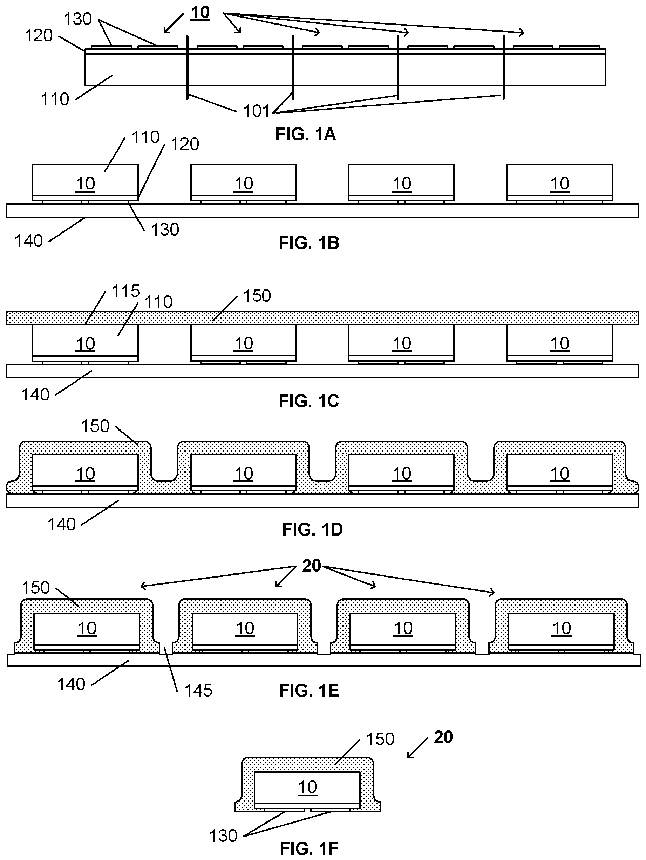

FIGs. 1A-1F illustrate an example process for forming a light emitting element with a wavelength conversion element.

FIG. 1A illustrates the forming/growing of multiple light emitting elements 120 upon a growth substrate 110. Each light emitting element 120 may typically include an active light emitting regions sandwiched between an N-type semiconductor region and a P-type semiconductor region. Conductive structures (not shown) are created during the formation of the light emitting elements 120 so as to provide contact pads 130 on the top-most layer of the light emitting element 120. In some embodiments, the contact pads 130 may be on opposite surfaces of the light emitting element 120. Individual light emitting structures 10 are formed by slicing/dicing 101 the growth substrate 110 with light emitting elements 120 to form individual (singulated) light emitting structures 10.

FIG. 1B illustrate the placement of the light emitting structures 10 on an intermediate, removable structure 140, such as a removable 'sawing tape' with an adhesive surface. As illustrated, the structures 10 are placed on the tape 140 in a 'flip-chip' orientation, with the contact pads 130 on the tape 140, and the growth substrate 110 above the light emitting element 120. In this example embodiment, the growth substrate 110 is not removed, and provides structural support and protection for the light emitting element 120, thereby allowing for the structure 10 to be subsequently processed without being attached to a carrier substrate, as in the example of FIGs. 3A-3B.

Other means for providing structural support to the light emitting element 120 may also be used. For example, copending U.S. patent application61/656,691, "CHIP SCALE LIGHT EMITTING DEVICE WITH METAL PILLARS IN A MOLDING COMPOUND FORMED AT WAFER LEVEL", filed 7 June 2012, for Jipu Lei, Stefano Schiaffino, Alexander Nickel, Mooi Guan Ng, Grigoriy Basin, and Sal Akram, (Attorney docket 2012PF00450) discloses that the conductor layers that form the connections between the contact pads 130 and the light emitting element 120 may be formed as thick metal pillars with dielectric material between the pillars, the encased pillars allowing the structure to be self-supporting.

To enhance light output efficiency through the growth substrate 110, the interface between the growth substrate 110 and the light emitting surface of the light emitting element 120 may be textured to reduce the amount of light that is totally internally reflected (TIR) at the interface. In an example embodiment, the growth substrate 110 may be a "Patterned Sapphire Substrate" (PSS) that allows the light emitting element 120 to be grown upon a patterned/textured surface of the growth substrate.

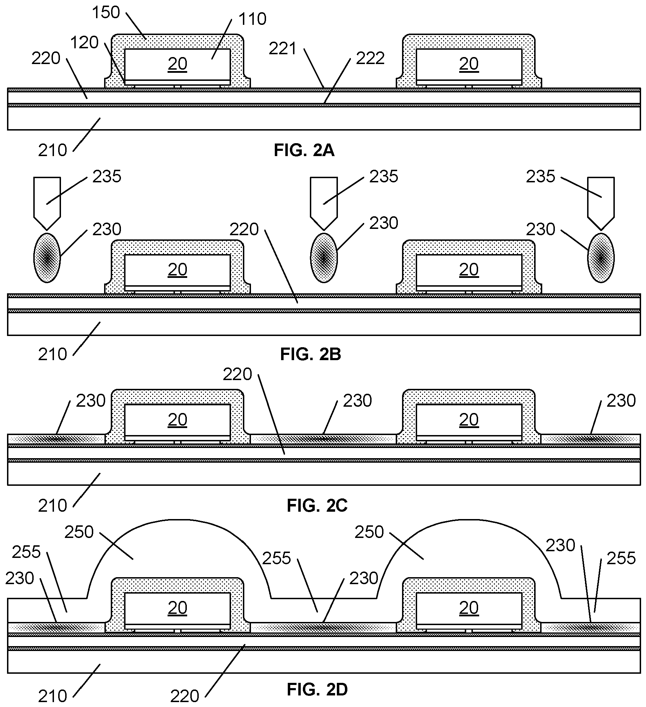

In this example embodiment, the light emitting structures 10 are spaced apart sufficiently to allow for a wavelength conversion material 150 to be applied to the top and sides of the light emitting structure 10, as illustrated in FIGs. 1C-1D. To enhance the light extraction efficiency, the upper surface 115 of the growth substrate 110 may be textured/roughened to reduce total internal reflections at the interface between the wavelength conversion material 150 and the growth substrate 110. Additionally (not illustrated), a layer of reflective material may be applied between the light emitting structures 10, to reflect any downward traveling light in an upward direction, as detailed further with regard to FIGs. 2A-2F.

In the example of FIG. 1C, a preformed laminate sheet of wavelength conversion material 150 is placed atop the light emitting structures 10, then processed to conform to the shape of the spaced apart structures 10 on the tape 140, as illustrated in FIG. ID. In an example embodiment, a combination of vacuum and heat is used to laminate the wavelength conversion material 150 to the light emitting structures 10, such as disclosed in USP 7,344,952 issued to Haryanto Chandra on 18 March 2008, and incorporated by reference herein.

If the light emitting structures 10 are pre-tested and sorted ('binned') by their light output characteristics, structures 10 with similar characteristics can be placed on the tape 140, and the preformed wavelength conversion sheet 150 may be selected such that its characteristics in conjunction with the light output characteristics of the light emitting structures 10 on the tape provide a desired composite light output.

One of skill in the art will recognize that the wavelength conversion material 150 need not be in the form of a laminate sheet; it may be applied in liquid or paste form via spray coating, molding, screen printing, and so on.

The light emitting structures 10 with wavelength conversion material 150, hereinafter termed 'structures 20' are subsequently singulated by slicing 145 the material 150 between the structures 20, as illustrated in FIGs. IE. Each of the structures 20 may subsequently be removed from the tape 140 as illustrated in FIGs. IF.

FIGs. 2A-2F illustrate an example process for forming a light emitting device with a light emitting element and an optical element with a reflective element, and without a carrier substrate. Typically, optical elements may be formed upon a light emitting device using a mold that forms the appropriate shape for achieving the desired optical effect. A silicone or other transparent material in a liquid or paste form may be used as the mold material, and, as noted above, this material may be infused with wavelength conversion material.

To withstand the stress imposed by a molding process, the light emitting structures 20, comprising a light emitting element 120, a growth substrate 110, and optional wavelength conversion material 150 are placed on a carrier substrate 210 that is sufficiently robust to support the light emitting structures 20 during this process. These structures 20 are situated on the carrier 210 with sufficient space between them to allow the formation of an optical element that surrounds each structure 20.

To facilitate an easy removal of the subsequently formed devices from the carrier 210, a double-sided adhesive tape 220 may be used to attach the structures 20 to the upper surface 221 of the tape 220, and the lower surface 222 of the tape 220 to the carrier 210, as illustrated in FIG. 2A. The tape 220 may include a thermal release coating on the surface 222 that is attached to the carrier 210, so that upon completion of the molding process, the tape 220 can be removed from the carrier 210 by curing it for a short time at a temperature that allows separation of the tape 220 from the carrier 210, allowing the carrier 210 to be reused.

At FIG. 2B, a dispenser 235 applies reflective material 230 to the spaces between the structures 20 on the tape 220. This reflective material 230 will serve to redirect any light directed to the bottom of the subsequently formed light emitting device back toward the intended light emitting surface of the optical element (not illustrated in FIG. 2B). This reflective material 230 may be a polymer with a highly reflective filler, such as TiO₂, which is applied in liquid or paste form, and is subsequently cured to form a smooth layer of this reflective material 230, as illustrated in FIG. 2C.

Optionally, depending upon the shape and other characteristics of the optical element, the reflective material 230 may be omitted, relying on total internal reflection (TIR) at the lower surface of the optical element to redirect light directed to this surface back toward the intended light emitting surface of the optical element. In some applications, the surface upon which the light emitting device is to be mounted may be reflective, and the reflective material 230 may be omitted.

At FIG. 2D, an optical element 250 is formed over each light emitting structure 20. In the example of FIG. 2D, the optical element 250 is in the form of a hemisphere above each light emitting structure 20, although any of a number of different shapes may be formed to achieve a particular light emission pattern, such as a collimated light emission pattern. To simplify manufacture, the mold material may be applied to the entire surface area of the carrier 210, such that the molding process produces the individual optical elements 250 connected together by the molding material 255 in the remaining spaces between the light emitting structures 20. Of particular note, the reflective material 230 lies below the optical elements 250 and the intervening material 255, so that light that may be directed downward through the optical elements 250 is reflected upward.

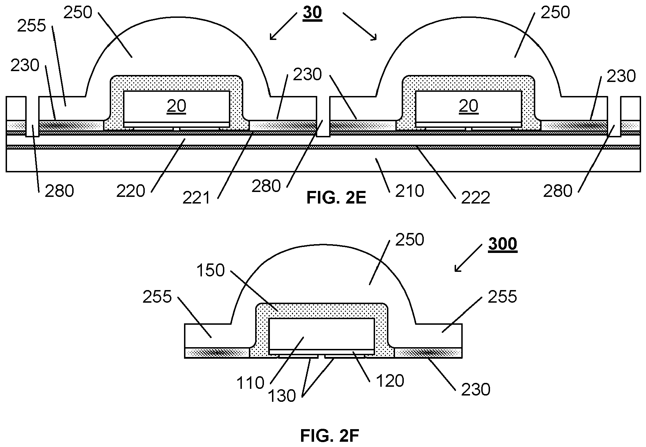

At FIG. 2E, the individual light emitting devices 30, comprising the light emitting structure 20, the reflective material 230, and the optical element 250, are singulated by slicing 280 through the optical element 250, reflective material 230, and into the tape 220, above the carrier 210. This partial slicing allows for the unmarred carrier 210 to be reused for forming other sets of light emitting devices.

After the partial slicing to singulate the light emitting devices 30, the tape 220 is removed from the devices 30 and the carrier substrate 210, forming individual light emitting devices 30 without elements of the carrier substrate 210, as illustrated in FIG. 2F.

One of skill in the art will recognize that the carrier substrate 210 may be removed before singulating the light emitting devices 30, leaving the devices 30 on the tape 220 for subsequent singulation.

The formed light emitting device 30 includes a light emitting element 120, a growth substrate element 110, an optional wavelength conversion material 150, and reflective material 230 below the optical element 250 and intervening material 255. As noted above, reflective material may also be placed beneath the wavelength conversion material 150.

Of particular note, the overall size of the light emitting device 30 includes the area occupied by the optical element 250 and material 255, and the amount of material 255 can be increased or decreased to provide a desired size or shape of the finished light emitting device 30. For example, in an application that uses a variety of different light emitting devices, the individual devices may be sized and shaped to fit together in a jig-saw like fashion.

The size and shape of the finished light emitting device 30 is defined by the mold used to create the optical elements 250 on the carrier 210 and/or by the slicing/trimming of the intervening material 255 between the light emitting structures 20, and is not at all defined by the carrier substrate 210. Alternatively stated, the same carrier substrate 210 may be used regardless of the size or shape of the device required to satisfy the criteria of a particular application for the device.

Additionally, because the carrier substrate 210 is reusable, and not 'consumed' in the process of creating the light emitting device 30, the cost of the substrate 210 is not a direct cost in the manufacture of each light emitting device 30. The cost of this substrate 210 is shared among all of the devices that will ever use this substrate 210, and thus the per-device cost of this substrate 210 is virtually infinitesimal.

While the invention has been illustrated and described in detail in the drawings and foregoing description, such illustration and description are to be considered illustrative or exemplary and not restrictive; the invention is not limited to the disclosed embodiments.

For example, it is possible to operate the invention in an embodiment wherein multiple light emitting elements are included in each light emitting structure, or multiple light emitting structures are encapsulated by a single optical element. Because a different carrier substrate is not required for each different combination of light emitting elements or light emitting structures within each optical element, the techniques of this invention provide substantial flexibility in the design and configuration of light emitting devices for varied applications.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A light emitting device comprising:
a self-supporting light emitting element (120) including an active region sandwiched between an N-type region and a P-type region, with conductive pads (130) on a surface of the light emitting element (120) that are coupled to the N-type and P-type regions, and
an optical element (250) that receives light emitted from the light emitting element (120) and emits light through one or more light emitting surfaces,
wherein the light emitting device is a discrete self-supporting device, and the surface that includes the conductive pads (130) forms an external surface of the light emitting device to facilitate coupling of the discrete device to an external source of power,
**characterized in that**,
the light emitting element (120) includes a conductive layer between the conductive pads (130) and the N-type an P-type regions that is sufficiently thick so as to provide self-support to the light emitting element (120).

2. The light emitting device of claim 1, including a growth substrate (110) upon which the light emitting element (120) was grown situated between the light emitting element (120) and the optical element (250), the growth substrate (110) enabling the light emitting element (120) to be self-supporting.

3. The light emitting device of claim 2, wherein the growth substrate (110) is a patterned sapphire substrate (PSS).

4. The light emitting device of claim 1, including a wavelength conversion material (150) that converts at least some of the light emitted by the light emitting element (120) into light of a different wavelength.

5. The light emitting device of claim 4, wherein the wavelength conversion material (150) is situated between the light emitting element (120) and the optical element (250).

6. The light emitting device of claim 5, including reflective material (230) that serves to reflect light from the wavelength conversion material (150) toward the one or more light emitting surfaces.

7. The light emitting device of claim 1, including a reflective element (230) that surrounds the light emitting element (120) on a plane parallel to the surface that includes the conductive pads (130), and serves to reflect light toward the one or more light emitting surfaces of the optical element (250).

8. The light emitting device of claim 1, including a plurality of light emitting elements (120), wherein the optical element (250) receives light emitted from each of the plurality of light emitting elements (120).

9. A method of forming a light emitting device comprising:
providing a carrier substrate (210),
situating a plurality of self-supporting light emitting structures (10, 20) on the carrier substrate (210), each device including an active region sandwiched between an N-type region and a P-type region, with conductive pads (130) on a surface of the light emitting element (120) that are coupled to the N-type and P-type regions,
applying an optical material over the light emitting structures (10, 20) on the carrier substrate (210),
molding the optical material to form optical elements (250) over the light emitting structures (10, 20),
slicing the optical material in the spaces between the light emitting structures (10, 20), and
detaching the carrier substrate (210) from the plurality of light emitting structures (10, 20) after the molding of the optical material,
**characterized in that**
the light emitting element (120) includes a conductive layer between the conductive pads (130) and the N-type an P-type regions that is sufficiently thick so as to provide self-support to the light emitting element (120).

10. The method of claim 9, including applying a reflective material (230) in spaces between the light emitting structures (10, 20) on the carrier substrate (210).

11. The method of claim 9, including a double sided tape (220) that serves to removably attach the plurality of light emitting structures (10, 20) to the carrier substrate (210).

12. The method of claim 11, wherein the double sided tape (220) includes a thermal release coating that facilitates the detaching of the carrier substrate (210).

13. The method of claim 9, including providing a wavelength conversion material (150) that is situated so as to convert at least some of the light emitted by the light emitting element (120) into light of a different wavelength.

14. The method of claim 13, wherein the wavelength conversion material (150) is situated between the light emitting elements (120) and the optical elements (250).

15. The method of claim 14, wherein the wavelength conversion material (150) is provided as a preformed sheet of wavelength conversion material.

## Patentansprüche

1. Lichtquelle, umfassend:
ein selbsttragendes Licht emittierendes Element (120), umfassend einen aktiven Bereich, der sandwichartig zwischen einer N-Typ-Region und einer P-Typ-Region angeordnet ist, wobei Leitpads (130) auf einer Oberfläche des Licht emittierenden Elements (120) mit den N- und P-Typ-Regionen gekuppelt sind, und
ein optisches Element (250), das Licht empfängt, das vom Licht emittierenden Element (120) emittiert wird, und Licht über mindestens eine Licht emittierende Oberfläche emittiert,
wobei die Lichtquelle eine diskrete selbsttragende Vorrichtung ist und die Oberfläche, die die Leitpads (130) umfasst, eine Außenfläche der Lichtquelle bildet, um die Kupplung der diskreten Vorrichtung mit einer externen Energiequelle zu unterstützen,
**dadurch gekennzeichnet, dass**
das Licht emittierende Element (120) eine leitfähige Schicht zwischen den Leitpads (130) und den N- und P-Typ-Regionen umfasst, die dick genug ist, um das Licht emittierende Element (120) selbsttragend zu machen.

2. Lichtquelle nach Anspruch 1, umfassend ein Wachstumssubstrat (110), auf dem das Licht emittierende Element (120) gezüchtet wurde, das zwischen dem Licht emittierenden Element (120) und dem optischen Element (250) angeordnet ist, wobei das Wachstumssubstrat (110) es dem Licht emittierenden Element (120) ermöglicht, selbsttragend zu sein.

3. Lichtquelle nach Anspruch 2, wobei das Wachstumssubstrat (110) ein Saphirsubstrat mit Oberflächengestalt (PSS) ist.

4. Lichtquelle nach Anspruch 1, umfassend ein Wellenlängenkonversionsmaterial (150), das mindestens einen Teil des vom Licht emittierenden Element (120) emittierten Lichts in Licht einer anderen Wellenlänge konvertiert.

5. Lichtquelle nach Anspruch 4, wobei das Wellenlängenkonversionsmaterial (150) zwischen dem Licht emittierenden Element (120) und dem optischen Element (250) angeordnet ist.

6. Lichtquelle nach Anspruch 5, umfassend ein reflektives Material (230), das Licht vom Wellenlängenkonversionsmaterial (150) in Richtung der mindestens einen Licht emittierenden Oberfläche reflektiert.

7. Lichtquelle nach Anspruch 1, umfassend ein reflektives Element (230), das das Licht emittierende Element (120) auf einer Ebene umgibt, die parallel zur Oberfläche, die die Leitpads (130) umfasst, verläuft, und Licht in Richtung der mindestens einen Licht emittierenden Oberfläche des optischen Elements (250) reflektiert.

8. Lichtquelle nach Anspruch 1, umfassend eine Mehrzahl Licht emittierender Elemente (120), wobei das optische Element (250) Licht empfängt, das von jedem der Mehrzahl Licht emittierender Elemente (120) emittiert wird.

9. Verfahren zur Bildung einer Lichtquelle, wobei das Verfahren umfasst:
Vorsehen eines Trägersubstrats (210);
Anordnen einer Mehrzahl selbsttragender Licht emittierender Elemente (10, 20) auf dem Trägersubstrat (210), wobei jede Vorrichtung einen aktiven Bereich umfasst, der sandwichartig zwischen einer N-Typ-Region und einer P-Typ-Region angeordnet ist, wobei Leitpads (130) auf einer Oberfläche des Licht emittierenden Elements (120) mit den N- und P-Typ-Regionen gekuppelt sind,
Anwenden eines optischen Materials auf die Licht emittierenden Strukturen (10, 20) auf dem Trägersubstrat (210),
Formen des optischen Materials, um optische Elemente (250) über den Licht emittierenden Strukturen (10, 20) zu bilden,
Schneiden des optischen Materials in den Bereichen zwischen den Licht emittierenden Strukturen (10, 20) und
Trennen des Trägersubstrats (210) von der Mehrzahl Licht emittierender Strukturen (10, 20) nach dem Formen des optischen Materials, **dadurch gekennzeichnet, dass**
das Licht emittierende Element (120) eine leitfähige Schicht zwischen den Leitpads (130) und den N- und P-Typ-Regionen umfasst, die dick genug ist, um das Licht emittierende Element (120) selbsttragend zu machen.

10. Verfahren nach Anspruch 9, umfassend Anwenden eines reflektiven Materials (230) in Bereichen zwischen den Licht emittierenden Strukturen (10, 20) auf dem Trägersubstrat (210).

11. Verfahren nach Anspruch 9, umfassend ein doppelseitiges Klebeband (220), das die Mehrzahl Licht emittierender Strukturen (10, 20) abnehmbar auf dem Trägersubstrat (210) befestigt.

12. Verfahren nach Anspruch 11, wobei das doppelseitige Klebeband (220) eine Wärmefreisetzungsbeschichtung umfasst, die das Abtrennen des Trägersubstrats (210) unterstützt.

13. Verfahren nach Anspruch 9, umfassend Vorsehen eines Wellenlängenkonversionsmaterials (150), das derart angeordnet ist, dass es mindestens einen Teil des vom Licht emittierenden Element (120) emittierten Lichts in Licht einer anderen Wellenlänge konvertiert.

14. Verfahren nach Anspruch 13, wobei das Wellenlängenkonversionsmaterial (150) zwischen den Licht emittierenden Elementen (120) und den optischen Elementen (250) angeordnet ist.

15. Verfahren nach Anspruch 14, wobei das Wellenlängenkonversionsmaterial (150) als vorgeformte Platte aus Wellenlängenkonversionsmaterial vorgesehen ist.

## Revendications

1. Dispositif électroluminescent comprenant :
un élément électroluminescent autoportant (120) comprenant une zone active prise en sandwich entre une zone de type N et une zone de type P, avec des plots conducteurs (130) sur une surface de l'élément électroluminescent (120) qui sont couplés aux zones de type N et de type P, et
un élément optique (250) qui reçoit la lumière émise par l'élément électroluminescent (120) et qui émet de la lumière par le biais d'une ou plusieurs surfaces électroluminescentes,
dans lequel le dispositif électroluminescent est un dispositif autoportant discret, et la surface qui comprend les plots conducteurs (130) forme une surface externe du dispositif électroluminescent afin de faciliter le couplage du dispositif discret à une source d'énergie externe,
**caractérisé en ce que**
l'élément électroluminescent (120) comprend une couche conductrice entre les plots conducteurs (130) et les zones de type N et de type P qui est suffisamment épaisse pour permettre à l'élément électroluminescent (120) d'être autoportant.

2. Dispositif électroluminescent selon la revendication 1, comprenant un substrat de développement (110) sur lequel l'élément électroluminescent (120) a été développé, situé entre l'élément électroluminescent (120) et l'élément optique (250), le substrat de développement (110) permettant à l'élément électroluminescent (120) d'être autoportant.

3. Dispositif électroluminescent selon la revendication 2, dans lequel le substrat de développement (110) est un substrat en saphir gravé (PSS).

4. Dispositif électroluminescent selon la revendication 1, comprenant un matériau de conversion de longueur d'onde (150) qui convertit au moins une partie de la lumière émise par l'élément électroluminescent (120) en une lumière d'une longueur d'onde différente.

5. Dispositif électroluminescent selon la revendication 4, dans lequel le matériau de conversion de longueur d'onde (150) est situé entre l'élément électroluminescent (120) et l'élément optique (250).

6. Dispositif électroluminescent selon la revendication 5, comprenant un matériau réfléchissant (230) qui sert à réfléchir la lumière issue du matériau de conversion de longueur d'onde (150) vers la ou les surfaces électroluminescentes.

7. Dispositif électroluminescent selon la revendication 1, comprenant un élément réfléchissant (230) qui entoure l'élément électroluminescent (120) sur un plan parallèle à la surface qui comprend les plots conducteurs (130), et sert à réfléchir la lumière vers la ou les surfaces électroluminescentes de l'élément optique (250).

8. Dispositif électroluminescent selon la revendication 1, comprenant une pluralité d'éléments électroluminescents (120), dans lequel l'élément optique (250) reçoit la lumière émise par chacun de la pluralité d'éléments électroluminescents (120).

9. Procédé de formation d'un dispositif électroluminescent comprenant :
le fait de prévoir un substrat porteur (210),
le placement d'une pluralité de structures électroluminescentes autoportantes (10, 20) sur le substrat porteur (210), chaque dispositif comprenant une zone active prise en sandwich entre une zone de type N et une zone de type P, avec des plots conducteurs (130) sur une surface de l'élément électroluminescent (120) qui sont couplés aux zones de type N et de type P,
l'application d'un matériau optique par-dessus les structures électroluminescentes (10, 20) sur le substrat porteur (210),
le moulage du matériau optique afin de former des éléments optiques (250) par-dessus les structures électroluminescentes (10, 20),
la découpe du matériau optique dans les espaces entre les structures électroluminescentes (10, 20),
et
le détachement du substrat porteur (210) de la pluralité de structures électroluminescentes (10, 20) après le moulage du matériau optique,
**caractérisé en ce que**
l'élément électroluminescent (120) comprend une couche conductrice entre les plots conducteurs (130) et les zones de type N et de type P qui est suffisamment épaisse pour permettre à l'élément électroluminescent (120) d'être autoportant.

10. Procédé selon la revendication 9, comprenant l'application d'un matériau réfléchissant (230) dans les espaces entre les structures électroluminescentes (10, 20) sur le substrat porteur (210).

11. Procédé selon la revendication 9, comprenant un ruban double face (220) qui sert à fixer de manière amovible la pluralité de structures électroluminescentes (10, 20) sur le substrat porteur (210).

12. Procédé selon la revendication 11, dans lequel le ruban double face (220) comprend un revêtement à libération thermique qui facilite le détachement du substrat porteur (210).

13. Procédé selon la revendication 9, comprenant le fait de prévoir un matériau de conversion de longueur d'onde (150) qui est situé de façon à convertir au moins une partie de la lumière émise par l'élément électroluminescent (120) en une lumière d'une longueur d'onde différente.

14. Procédé selon la revendication 13, dans lequel le matériau de conversion de longueur d'onde (150) est situé entre les éléments électroluminescents (120) et les éléments optiques (250).

15. Procédé selon la revendication 14, dans lequel le matériau de conversion de longueur d'onde (150) est prévu comme une feuille préformée de matériau de conversion de longueur d'onde.
